# EUROPEAN PATENT APPLICATION

(11) **EP 1 988 580 A1**
(43) Date of publication of application: **05.11.2008**
(21) Application number: 07107573.3
(22) Date of filing: 04.05.2007
(51) Int. Cl.: H01L 31/024, H01L 23/34

(54) **Optical device cooling apparatus and method**

(71) Applicant: STMicroelectronics (Research & Development) Limited, Marlow, Buckinghamshire SL7 1YL (GB)
(72) Inventor: Richardson, Justin, Edinburgh, Lothian EH3 5QP (GB)
(74) Representative: McBride, Peter Hill

(57) **Abstract**

An optical device cooling apparatus (100) comprises an image sensor array (102) and a MEMS fan (104). The MEMS fan (104) is formed integrally with the image sensor array (102) and cools the image sensor array (102).

## Description

This invention relates to an optical device cooling apparatus. More particularly, but not exclusively, it relates to an optical device cooling apparatus suitable for use with a sealed optical sensing unit.

Complimentary metal oxide semiconductor (CMOS) image sensors allow the fabrication of digital logic on the same semiconducting substrate as a photo sensitive array.

All CMOS devices consume power and accordingly dissipate heat. A consequence of the presence of digital logic alongside an image sensor is increased heat dissipation from the semiconducting substrate. In the case of hermetically sealed camera modules incorporating a CMOS image sensor and the accompanying digital logic the heating effect is exacerbated due to the localisation of the heat dissipated. This is due in part to poor thermal conductivity between the semiconducting substrate and the packaging of the camera.

Heating of a CMOS image sensor causes a deterioration in the performance of the image sensor. This is because pixels have a leakage current, also known as 'dark current', associated with them which doubles with every 8°C in temperature rise. Such a leakage current is indistinguishable from current generated by optically generated current and accordingly can give rise to artefacts in images. Leakage current artefacts are most appreciable in images in which long exposures are used as the signal due to optically generated current is small compared to the signal due to leakage current.

According to a first aspect of the present invention there is provided an optical device cooling apparatus comprising an image sensor array and a Micro-Electro-Mechanical Systems (MEMS) cooling device, the cooling device being arranged to cool the image sensor array.

Such an apparatus reduces the localised heating effect of power dissipation at the image sensor array by producing an airflow. Consequently such an apparatus militates against increase leakage current artefacts in images captured using the image sensor array.

The MEMS device may be a fan. The MEMS device may be formed integrally with the image sensor array. The MEMS device may be formed from a substrate of the image sensor array.

According to a second aspect of the present invention there is provided an optical sensor module comprising an optical device cooling apparatus according to the first aspect of the present invention.

The optical sensor module may comprise a housing in which the image sensor array is housed. The housing may be sealed, preferably hermetically.

According to a third aspect of the present invention there is provided an image capture device comprising an optical device cooling apparatus according to the first aspect of the present invention.

The image capture device may comprise an optical sensor module according to the second aspect of the present invention.

The image capture device may comprise any one of the following: digital stills camera, digital video camera, mobile telephone, web-cam, endoscope.

The invention will now be described, by way of example only, with reference to the accompanying drawings, in which:
Figure 1 is a schematic diagram of an embodiment of an optical device cooling apparatus according to an aspect of the present invention; and
Figure 2 is a schematic diagram of an image capture device comprising the cooling apparatus of Figure 1.

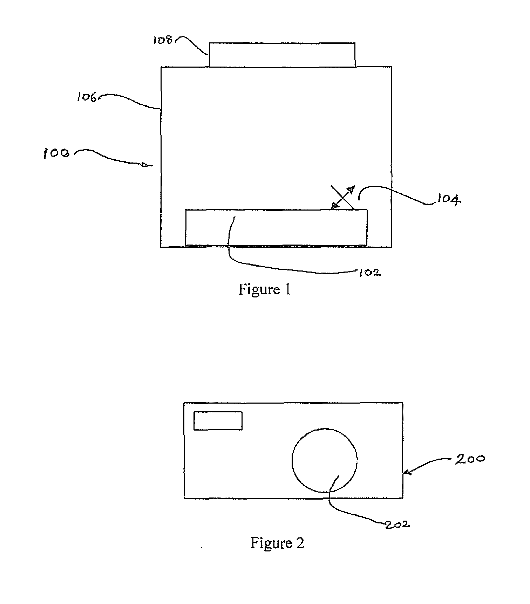

Referring now to Figure 1, an optical sensor module 100 comprises an image sensor array 102, a MEMS fan 104, a sealed housing 106 and a lens holder 108.

The sensor array 102 and fan 104 are mounted within the housing 106 and the lens holder 108 is o mounted externally of the housing 106, in line of sight of the sensor array 102.

In a preferred embodiment, the sensor array 102 and the MEMS fan 104 are integrally formed with one another. Typically the MEMS fan 104 is formed from substrate 110 of the image sensor array 102.

In use, the fan draws power from a power supply and is driven using a suitable motor as is known to a person skilled in the art. The fan 104 circulates air within the housing such that a convective flow of air is formed within the housing 106. Such a flow allows the dissipation of heat generated at the sensor array 102 through the walls of the housing 106 thereby reducing the heat loading on the sensor array 102. The reduction in heat loading at the sensor array 102 results in a consequential reduction in the leakage current from the pixels of the sensor array 102.

The degree of cooling of the sensor array 102 varies with the rate of flow induced within the housing by the fan 104. This will be dependent upon the size and number of blades of the fan, and also upon the speed of rotation, or oscillation, of the blades of the fan.

Referring now to Figure 2 a camera 200 comprises an optical sensor module 202 as described hereinbefore with reference to Figure 1.

It will be appreciated that although described with reference to a camera the optical sensor module 202 may form a constituent part of any of the following: digital stills camera, digital video camera, mobile telephone, web-cam, endoscope, bar code reader, biosensor.

While various embodiments of the invention have been described, it will be apparent to those skilled in the art once given this disclosure that various modifications, changes, improvements and variations may be made without departing from the scope of the invention.

## Claims

1. An optical device cooling apparatus comprising an image sensor array (102) and a Micro-Electro-Mechanical Systems (MEMS) cooling device (104), the cooling device (104) being arranged to cool the image sensor array (102).

2. Apparatus according to claim 1 wherein MEMS device (104) is formed integrally with the image sensor array.

3. Apparatus according to claim 2 wherein the MEMS device (104) comprises a fan.

4. Apparatus according to either claim 2 or claim 3 wherein the MEMS device (104) is formed from a substrate of the image sensor array (102).

5. An optical sensor module (100) comprising an optical device cooling apparatus according to any one of claims 1 to 4.

6. A module according to claim 5 comprising a housing (106) in which the image sensor array (102) is housed.

7. A module according to claim 6 wherein the housing (106) is sealed.

8. An image capture device (200) comprising an optical device cooling apparatus according to any one of claims 1 to 4.

9. A device according to claim 8 comprising an optical sensor module (100) according to any one of claims 5 to 7.

10. A device according to either claim 8 or claim 9 comprising any of the following: digital stills camera, digital video camera, mobile telephone, web-cam, endoscope, bar code reader, biosensor.

## Amended claims

### Amended claims in accordance with Rule 137(2) EPC.

**1.** An integrated circuit device comprising an integrated circuit and a Micro-Electro-Mechanical Systems (MEMS) cooling device (104) arranged to cool the integrated circuit;
**characterised in that** the integrated circuit is image sensor array (102);
the device further includes a sealed housing (106) containing the image sensor array (106) and the MEMS cooling device (104);
and the sealed housing provides a lens mount (108).

**2.** A device according to claim 1 wherein MEMS device (104) is formed integrally with the image sensor array (106).

**3.** A device according to claim 2 wherein the MEMS device (104) comprises a fan.

**4.** A device according to either claim 2 or claim 3 wherein the MEMS device (104) is formed from a substrate of the image sensor array (102).

**5.** An image capture device (200) comprising an integrated circuit device according to any one of claims 1 to 4.

**6.** An image sensor device according to claim 5 comprising any of the following: digital stills camera, digital video camera, mobile telephone, web-cam, endoscope, bar code reader, biosensor.
